(19) Europäisches Patentamt
European Patent Office
Office européen des brevets

(11) Veröffentlichungsnummer: 0 305 873
A2

(12) # EUROPÄISCHE PATENTANMELDUNG

(21) Anmeldenummer: 88113763.2

(51) Int. Cl.$^4$: G03F 7/08

(22) Anmeldetag: 24.08.88

(30) Priorität: 31.08.87 DE 3729035

(43) Veröffentlichungstag der Anmeldung: 08.03.89 Patentblatt 89/10

(84) Benannte Vertragsstaaten: DE FR GB NL

(71) Anmelder: HOECHST AKTIENGESELLSCHAFT
Postfach 80 03 20
D-6230 Frankfurt am Main 80(DE)

(72) Erfinder: Stephani, Trutz-Ulrich, Dr.
Dorfener Strasse 25
D-8058 Erding(DE)
Erfinder: Mohr, Dieter, Dr.
Eaubonner Strasse 8
D-6501 Budenheim(DE)
Erfinder: Maisel, Britta
Ginsheimer Strasse 4
D-6094 Bischofsheim(DE)
Erfinder: Frass, Hans Werner, Dr.
Erbsenacker 37
D-6200 Wiesbaden(DE)
Erfinder: Elsässer, Andreas, Dr.
Hertastrasse 1 b
D-6270 Idstein(DE)

(54) **Positiv arbeitendes lichtempfindliches Gemisch und daraus hergestelltes photolithographisches Aufzeichnungsmaterial.**

(57) Es wird ein positiv arbeitendes lichtempfindliches Gemisch, im wesentlichen enthaltend ein o-Chinondiazid und ein Bindemittel, beschrieben, welches dadurch gekennzeichnet ist, daß das Gemisch eine Verbindung enthält, die mit dem o-Chinondiazid eine Azokupplung ausbilden kann.

Ein mit dem lichtempfindlichen Gemisch hergestelltes Aufzeichnungsmaterial weist eine hohe Lichtempfindlichkeit und eine besondere Entwicklerresistenz auf.

Das lichtempfindliche Gemisch findet Anwendung in der Reproduktionstechnik, aber auch auf dem Resistgebiet.

EP 0 305 873 A2

# Positiv arbeitendes lichtempfindliches Gemisch und daraus hergestelltes photolithographisches Aufzeichnungsmaterial

Die Erfindung betrifft ein lichtempfindliches Gemisch, ein daraus hergestelltes photolithographisches Aufzeichnungsmaterial und ein Verfahren zu dessen Herstellung. Das lichtempfindliche Gemisch enthält im wesentlichen ein o-Chinondiazid und ein Bindemittel.

Es ist bekannt, o-Chinondiazide als lichtempfindliche Substanzen bei der Herstellung von Photokopien, Photoresistmaterialien sowie in den lichtempfindlichen Schichten lithographischer Druckplatten neben alkalilöslichen Bindemitteln, die mit den o-Chinondiaziden verschnitten und/oder an diese chemisch gebunden sind, zu verwenden.

Die Bindemittel enthalten meist phenolische Hydroxylgruppen und bestehen vorzugsweise aus oligomeren Verbindungen mit Molekulargewichten kleiner als 10.000 Dalton. Bevorzugt werden Novolake, insbesondere Kresol-Aldehydkondensationsprodukte oder Pyrogallol-Acetonharze entsprechend der US-A-3,635,709. Darüber hinaus werden Polyhydroxystyrol (DE-A-2 322 230) und Polymonomethacrylate mehrwertiger Phenole (DE-A-3 528 929 und 3 528 930) als Bindemittel vorgeschlagen.

Je höher der o-Chinondiazidgehalt in der Mischung ist, desto unlöslicher ist die Schicht in Alkali. Beim Belichten der Mischung mit aktinischer Strahlung wandelt sich das o-Chinondiazid in eine Carbonsäure um, wodurch sich die Alkalilöslichkeit der Schicht erhöht. Der Unterschied in der Alkalilöslichkeit zwischen belichteten und nichtbelichteten Bereichen einer bildmäßig belichteten photolithographischen Schicht ist Voraussetzung, um diese entwickeln zu können.

Der Gehalt an o-Chinondiazid der Mischung bestimmt aber auch die Lichtempfindlichkeit einer solchen photolithographischen Mischung; und zwar je geringer der Gehalt ist, um so höher ist die zu erwartende Lichtempfindlichkeit. Andererseits werden bei zu geringem Gehalt an o-Chinondiazid die Unterschiede in der Löslichkeit zwischen Bildstellen und Nichtbildstellen schlechter, so daß aufgrund mangelnder Differenzierung feine Strukturen zunehmend wegentwickelt werden.

In den beiden deutschen Patentschriften 875 437 und 893 748 werden positiv arbeitende lichtempfindliche, wasserunlösliche Diazoverbindungen, die zur Herstellung von Druckformen auf metallischen Unterlagen aufgebracht werden, mit Azokomponenten versetzt. Die nach der Belichtung entstehenden Azofarbstoffe sollen den Haftgrund für die fette Druckfarbe auf der Druckform ermöglichen. Um die Bildung von Azofarbstoffen auf den von Licht getroffenen Stellen zu vermeiden, werden langsam kuppelnde Diazoverbindungen bevorzugt. Die lichtempfindlichen Schichten enthalten kein Bindemittel, eine Steigerung der Lichtempfindlichkeit durch die Anwesenheit von Kupplungsreagenzien wird nicht beobachtet.

In der EP-A-0 010 749 wird zur Verbesserung der Lichtempfindlichkeit eines positiv arbeitenden lichtempfindlichen Gemisches vorgeschlagen, diesem Gemisch, bestehend aus einem o-Chinondiazidsulfon- oder -carbonsäureester oder einem -carbonsäureamid und einem in Alkali löslichen und in Wasser unlöslichen Phenolharz, ein Kondensationsprodukt aus einem Hydroxybenzophenon mit Formaldehyd zuzusetzen. Der Nachteil besteht allerdings in einer zu weichen Gradation.

Aufgabe der Erfindung war es daher, ein positiv arbeitendes lichtempfindliches Gemisch vorzuschlagen, das eine höhere Lichtempfindlichkeit als bisher bekannte Systeme zeigt, andererseits aber auch ein gutes Auflösungsvermögen und eine gute Entwicklerresistenz besitzt.

Gelöst wird die Aufgabe durch Bereitstellen eines lichtempfindlichen Gemisches, das im wesentlichen ein o-Chinondiazid und ein Bindemittel enthält, dadurch gekennzeichnet, daß das lichtempfindliche Gemisch eine Verbindung enthält, die mit dem o-Chinondiazid eine Azokupplung ausbilden kann.

Als Verbindungen, die mit einer Diazoniumverbindung eine Azokupplung ausbilden können - im folgenden Kuppler genannt -, werden erfindungsgemäß methylenaktive Verbindungen und/oder aromatische bzw. heteroaromatische Verbindungen mit mindestens einem, die elektrophile Substitution am Kern fördernden, Substituenten eingesetzt. Als die eine elektrophile Substitution am Kern fördernden Substituenten werden Hydroxylgruppen bevorzugt. Unter den Kupplern werden allerdings vorzugsweise methylenaktive Verbindungen verwendet. Die erfindungsgemäßen Kuppler besitzen bevorzugt eine mittlere bis hohe Kupplungsgeschwindigkeit.

Insbesondere werden Kuppler bevorzugt, die sowohl in der organischen Beschichtungslösung als auch im alkalischen Entwickler löslich sind. Das Kupplungsprodukt des o-Chinondiazids mit dem Kuppler muß dagegen im wäßrig-alkalischen Entwickler mäßig löslich sein, damit einerseits das gekuppelte o-Chinondiazid in den belichteten Stellen überhaupt im hinreichenden Ausmaß in Lösung gehen kann, andererseits aber dieses Produkt in den unbelichteten Stellen nicht soweit durch den Entwickler ausgewaschen werden kann, daß das Auflösungsvermögen und die Entwicklerresistenz der unbelichteten Schicht wesentlich abnimmt.

Die Kupplungsreaktion zwischen Diazoverbindungen und Kupplungsreagenzien ist bei V.V. Ershov, G.A.

Nikiforov, C.R.H.J. de Jonge, Quinone Diazides, Elsevier Scientific Publishing Company, Amsterdam-Oxford-New York, S. 114 ff. (1981) beschrieben.

Eine Zusammenfassung der in Frage kommenden Kupplungsreagenzien findet man bei M.S. Dinaburg, Photosensitive Diazo-Compounds, The Focal Press, London and New York, S. 96 ff. (1967).

Als erfindungsgemäß einzusetzende methylenaktive Verbindungen kommen Verbindungen der Formel I

$$(R_1)_n - Q - CH_2 - \overset{\overset{\displaystyle O}{\|}}{C} - R_2 \qquad I,$$

in Frage, worin n = 1, Q = Carbonyl und
n = 0, Q = Cyano bedeutet,
$R_1$, $R_2$ gleich oder verschieden sind und Alkyl, Cycloalkyl, Alkoxy, Alkyl-, Aryl- oder Acylamino, Alkoxycarbonylamido, Heteroaryl oder Heteroarylimino bedeuten. Bevorzugt sind $(C_1$-$C_3)$Alkyl, $(C_1$-$C_4)$-Alkoxy und $(C_1$-$C_4)$Alkylamino sowie $(C_6$-$C_{12})$Arylamino.

Besonders bevorzugt bei n = 1 und Q = Carbonyl ist
$R_1$ gleich Methyl und
$R_2$ vorzugsweise $(C_2$-$C_4)$Alkylamino oder $(C_6$-$C_{12})$Arylamin, insbesondere $C_6$-Arylamino, wobei der Arylrest auch substituiert sein kann durch $(C_1$-$C_3)$Alkyl bzw. -Alkoxy, Hydroxyl, Halogen oder Aminocarbonyl, insbesondere durch N-Hydroxyalkylamino carbonyl oder Aminosulfonyl.
$R_2$ kann aber auch verbindendes Glied zweier Reste der Formel $(R_1)_n$-Q-$CH_2$-$\overset{\overset{\displaystyle O}{\|}}{C}$- sein, in denen bei n = 1 und Q = Carbonyl $R_1$ vorzugsweise gleich Methyl ist, $R_2$ ein aliphatisches, cycloaliphatisches oder aromatisches Diamin bedeutet, insbesondere mit $(C_1$-$C_4)$Alkyl oder $(C_2$-$C_6)$Cycloalkyl, wobei ein Ring mit 2 Stickstoffatomen als Ringglieder und zusätzlichen 4 C-Atomen als Ring-C-Atome bevorzugt ist. Bei aromatischen Diaminen ist die meta-Stellung der Aminogruppen bevorzugt.

Insbesondere bevorzugt ist, wenn
$R_1$ und $R_2$ miteinander verbunden sind und einen aus 5 oder 6, insbesondere aus 6 Ringgliedern bestehenden cycloaliphatischen Rest ausbilden, der ggf. durch Alkyl, insbesondere durch $(C_1$-$C_3)$Alkyl substituiert ist oder ggf. Heteroatome wie Stickstoff, Schwefel und Sauerstoff, aber auch Carbonylgruppen enthalten kann,und insbesondere ein Aminocarbonylamino bildet.

Weniger bevorzugt ist, wenn n = 0 und Q = Cyano ist, wobei
$R_2$ vorzugsweise Aryl, Heteroaryl oder Heteroarylimino, Alkoxycarbonylamido oder Alkylamino ist. Insbesondere werden Arylreste mit 6 bis 10 C-Atomen und 5, 6, 9 oder 10gliedrigen, ein- bis zweikernigen Heteroarylresten bevorzugt, wie z.B. Benzofuranyl oder Benzothiofuranyl, insbesondere Thioindoxyl oder Naphthyl, ggf. substituiert durch Alkyl, Alkoxy oder Halogen, sowie Heteroaryliminoresten, insbesondere Iminodihydrochinolinyl oder Iminohydrobenzthiazolyl, ggf. auch substituiert durch Alkyl, Alkoxy oder Halogen.

Als methylenaktive Verbindungen werden genannt: aromatische und cycloaliphatische Amide der Acetessigsäure, wie beispielsweise Anilide, insbesondere m-Hydroxy-anilid und o-Chloranilid, aber auch Benzylanilid, p-Aminosulfonylanilid, p-Aminocarbonylanilid, daneben Cyclohexylamide, aber auch Amide von Diaminoverbindungen, wie beispielsweise von 1,2-Diaminoethan, von Diaminoverbindungen höherer Alkylverbindungen einschließlich von cycloaliphatischen Diaminoverbindungen wie beispielsweise Piperazin. Hierzu gehören auch Diaminophenylverbindungen, insbesondere m-Diaminobenzol. Besonders bevorzugte methylenaktive Verbindungen sind Acetylacetanilid, m-Hydroxy-acetylacetanilid, 4-Acetylacetamino-N-hydroxyethyl-benzamid und m-Bisacetylacetaminobenzol.

Neben den Abkömmlingen der Acetessigsäure werden auch Abkömmlinge der Malonsäure, wie deren Ester und Amide, einschließlich der zu einem 5- oder 6-gliedrigen Ring geschlossenen cyclischen Ester und Amide verwendet. Besonders bevorzugt hierunter ist die Barbitursäure.

Zu den Vertretern der 1,3-Dicarbonylverbindungen zählen offenkettige Verbindungen mit insgesamt 1 bis 8 C-Atomen, aber auch cyclische, insbesondere mit insgesamt 6 Ring-C-atomen. Bevorzugt wird hierbei Dimedon.

Als weitere Gruppe der unter die Formel I zählenden Verbindungen werden die Abkömmlinge der Cyanessigsäure genannt, wobei insbesondere die Cyanacetamide, wie Cyanacetanilid, Cyanaceturethan, Cyanacetharnstoff, aber auch Amide von Heterocyclen wie beispielsweise 2-(ω-Cyanoacetylimino)-1-methyl-dihydrochinolin, 1-(ω-Cyanoacetylimino)-2-methyl-6-ethoxydihydrobenzothiazol zu nennen sind. Zu den Abkömmlingen der Cyanessigsäure zählen auch deren Ester und Thioester, wie beispielsweise 2-Cyanoacetbenzofuran, 2-Cyanoacet-3-hydroxy-thionaphthen, aber auch Cyanomethylphenylketone.

Zu den erfindungsgemäßen aromatischen Verbindungen, die mindestens eine Hydroxylgruppe tragen,

zählen Verbindungen der Formel II

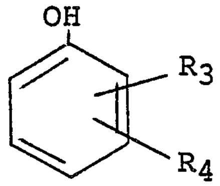

II,

worin

$R_3$, $R_4$ gleich oder verschieden sind und Wasserstoff, Alkyl, Cycloalkyl, ggf. Aryl, Heteroaryl, Alkoxy, Hydroxyl, ω-Hydroxylalkoxy, Aryl, Acyl, Amino, Aminoalkyl und Amidoacyl bedeuten.

Insbesondere werden ($C_1$-$C_3$)Alkyl, vorzugsweise Methyl, ($C_1$-$C_3$)Alkoxy, Hydroxyl, ω-Hydroxy($C_1$-$C_3$) alkoxy, Aryl, vorzugsweise Phenyl, der direkt gebunden sein kann, aber auch über ($C_1$-$C_4$)Alkylen, O, NH, S, SO oder $SO_2$ verbrückt sein kann und der ggf. durch Alkyl, Alkoxy, Halogen oder bevorzugt durch Hydroxyl substituiert sein kann, wobei insbesondere nur $R_3$ Aryl bedeutet, während $R_4$ Hydroxyl, vorzugsweise in meta-Stellung ist,

Säuregruppen, wie Carboxyl oder Sulfonyl und deren Derivate wie Carboxylamid oder Sulfonylamid, ggf. substituiert am Stickstoff durch Alkyl, Aryl, Hydroxyaryl oder Hydroxyl, vorzugsweise zu N-Hydroxyalkylamid,

Amino, wie $-NH_2$, $-NHR_5$ und $-NR_5R_6$, worin $R_5$ und $R_6$ gleich oder verschieden sind und Alkyl, insbesondere ($C_1$-$C_3$)Alkyl, Aryl, insbesondere Phenyl, Carboxyl, Amidocarboxyl, Carbonyl, Oxocarboxylester, Carboxylalkyl sowie Sulfonylalkyl bevorzugt.

Besonders bevorzugt ist, wenn $R_3$ gleich einer Hydroxylgruppe ist und diese bezüglich der ersten Hydroxylgruppe in meta-Stellung steht, wobei $R_4$ gleich Wasserstoff oder Amidocarboxyl bedeutet, welches durch Hydroxyalkyl am Stickstoff substituiert ist und bevorzugt in ortho- oder meta-Stellung zur Hydroxylgruppe steht,

$R_3$ und $R_4$ zusammen mindestens ein aromatisches carbocyclisches System bilden, jeweils bevorzugt bestehend aus sechs Ringgliedern, insbesondere einen Phenylrest, der ggf. substituiert ist, vorzugsweise in dessen Position 5 und/oder 8 durch Alkyl, insbesondere ($C_1$-$C_3$)Alkyl, Acyl, insbesondere Sulfonyl, Sulfonylamid, Acylamino, insbesondere nach der Formel $-NH-CO-R_7$, wobei $R_7$ Alkyl, insbesondere ($C_1$-$C_{12}$)Alkyl, Aryl, insbesondere Phenyl, das ggf. substituiert ist, vorzugsweise in meta-Position durch Alkyl, Halogen, Nitro oder Sulfonylamid.

Als Verbindungen bzw. Verbindungsklassen sind besonders zu nennen:

Alkylphenole, einschließlich der ortho- und meta-Kresole, 2,5,6-Trimethylphenol, 2-Hydroxymethylphenol, β-(2-Hydroxyphenyl)-propionsäure, 2-(ω-Phenylaminomethyl)-phenol, β-(4-Methyl-2-hydroxyphenyl)-glutarsäure, 2,5-Dimethyl-6(N-dimethylaminomethyl)-phenol, Dialkoxyphenole, z.B. der 1,3-Dimethylether des Pyrogallols.

Daneben sind zu nennen N-Lauryl-p-amino-phenol und N-Acyl-m-aminophenole, z.B. m-Hydroxyacetanilid, N-Hydroxyphenylthioharnstoff und ihre Analoga.

Einige komplexe Derivate von Alkylphenolen sind z.B. 2,5Dimethyl-4-morpholinomethylphenol, 2-Methyl-5-isopropyl-4-morpholinoethylphenol und 2,5-Dimethyl-4-dimethylaminome thylphenol und die mit Alkylresten substituierten Derivate.

Ebenso geeignet sind Derivate der Hydroxy-benzoesäuren, vorzugsweise die Amide, einschließlich der β-Hydroxyethylamide, der 2,5-Dimethyl-6-hydroxybenzoesäure, der 2-Isopropyl-5-methyl-6-hydroxybenzoesäure, der 2-Hydroxy-4-methylbenzoesäure und der Salicylsäure.

Resorcin und dessen Derivate werden vorzugsweise eingesetzt. Hierzu zählen dessen Alkylether, z.B. die Ethyl-, Methyl-, β-Hydroxyethyl-β-sulfoethyl-, 4-Sulfophenyl- und der β-Bromethylether, aber auch die Monomethylether des 4-Morpholinomethylresorcins, des N,N-Diethylaminoethylresorcins, der 3-Hydroxyphenoxyessigsäure sowie die Monoester des Resorcins, wie beispielsweise Monoacetate und Monoaminoethylcarbonate.

Bevorzugt werden solche Derivate des Resorcins wie z.B. 2,4-Dihydroxybenzolsulfonsäure, insbesondere 2,4-Dihydroxybenzol, Carbonsäuren und deren Derivate, insbesondere deren Amide und N-Hydroxyalkylamide. Daneben können auch 3,5-Dihydroxy-benzoesäure, 2,4,6-Tribrom-3,5-dihydroxybenzoesäure, die N-Hydroxyalkylamide der 2,4-Dihydroxybenzoesäure, der 3,5-Dihydroxybenzoesäure und der 4-Methoxy-2-hydroxybenzoesäure Verwendung finden.

Besonders bevorzugt sind Resorcin, 2,4-Dihydroxy-N-hydroxyethylbenzamid, 3,5-Dihydroxy-N-hydroxyethylamid und der Resorcinmonohydroxyethylether.

Verbindungen, die durch Ausbildung eines aromatischen Ringsystems über die Reste $R_5$ und $R_6$ entstehen, leiten sich vorzugsweise von β-Naphthol ab. Zu nennen sind beispielhaft die Sulfonsäuren 1-Naphthol-3-sulfonsäure, 1,8-Dihydroxynaphthalin-4-sulfonsäure, 1,8-Aminonaphthol-5-sulfonsäure, 1,8-Benzoylaminonaphthol-2-sulfonsäure und 1,8-Dihydroxynaphthalin-6-sulfonsäure, wobei deren Amide, Anilide und Ester bevorzugt sind.

Als Amide kommen beispielsweise auch N-β-Hydroxyethylamid, N,N-Bis-β-hydroxyethylamid, N-o-Methoxyphenylamid, N-2,3′-Dihydroxypropylamid, Aminoalkylamide oder Dihydroxyarylamide in Frage.

Ebenso werden erfindungsgemäß eingesetzt Alkylamino- und Acylaminonaphthole, worunter beispielhaft genannt werden:
1-(N-Carbethoxymethylamino)-8-naphthol-4-sulfonsäure, 5-(p-Nitro)-benzamido-1-naphthol und 3′-Aminobenzoylnaphthylamin.

Als erfindungsgemäß eingesetzte heterocyclische Verbindungen werden Verbindungen der Formel III

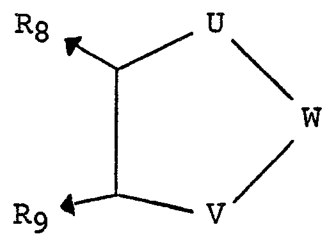

III,

verwendet, worin

U,V,W gleich oder verschieden sind, vorzugsweise aber verschieden sind und jeweils eine der folgenden unterschiedlichen Gruppen bedeuten: Methylen, ggf. substituiert durch Alkyl, Aryl, insbesondere Phenyl, Carboxyl, Carboxylamid; Carbonyl, Carbonylimino, Schwefel, Selen, Sauerstoff, Amino, Imino, ggf. substituiert durch Alkyl oder Aryl, wobei vorzugsweise U und W, ggf. auch V Amino bzw. Imino bedeuten, oder U vorzugsweise Sauerstoff, Schwefel oder Selen, V Schwefel oder Stickstoff und W Carbonyl, Carbonylimino oder Methylen bedeuten, oder U Methylen, V ggf. substituiertes Methylen und W Schwefel, besonders bevorzugt bedeuten U und W Amino bzw. Imino und V Carbonyl;

$R_8$ und $R_9$ gleich oder verschieden sind und Wasserstoff, Alkyl, insbesondere $(C_1$-$C_{11})$Alkyl, bevorzugt $(C_1$-$C_3)$Alkyl, Hydroxyl oder Oxo bedeuten, $R_8$ und $R_9$ ein carbocyclisches, vorzugsweise aromatisches Ringsystem aus 6 bis 10 Ringatomen bilden, insbesondere Phenyl, ggf. substituiert durch Alkyl und/oder Hydroxyl.

Besonders bevorzugt ist
$R_8$ Wasserstoff
$R_9$ $(C_1$-$C_3)$Alkyl,
V und W Amino bzw. Imino und
U Carbonyl.

Folgende Verbindungen bzw. Verbindungsklassen werden bevorzugt:
Derivate der Imidazole, Thiazole und Selenazole, z.B. Hydroxynaphthimidazole, 4-Hydroxybenzimidazole und deren 2-alkyl-substituierten Derivate, insbesondere die 2-Methyl- oder 2-Propyl-4-hydroxybenzimidazole, auch 6-Hydroxy-1,3-benzoxathiolon-2 und 6-Hydroxy-5-dimethylamino-1,3-benzoxathiolon.

Daneben werden erfindungsgemäß eingesetzt: Hydroxybenzotriazole, wie beispielsweise 7-Methyl-4-hydroxybenzotriazol, 1,7-Dimethyl-4-hydroxy-benzotriazol, 5,7-Dihydroxy-N-methyl-benzotriazol, 5,6-Dihydroxybenzotriazol.

Eine andere Gruppe bildet die Klasse der Thiophene, z.B. 3-Hydroxythiophen-5-carbonsäure, 2-Hydroxy-5-methylthiophen-4-carbonsäure und ihre Derivate, vorzugsweise die Methylester oder Dimethylamide.

Besonders bevorzugt werden Pyrazolone. Zu den Derivaten zählen die in Position 1 und/oder 3 mit Alkyl, Aryl oder Acyl substituierten Verbindungen, wie z.B. 1-Phenyl-3-methylpyrazolon-5, 1-(3′-Sulfonamido)-phenyl-3-methylpyrazo lon-5,1-[3′-(γ-Hydroxypropyl)-sulfonamido]-phenyl-3-methylpyrazolon-5 und 1-Aryl-3-carboxypyrazolone. Vorzugsweise werden die Derivate benutzt, die in Position 1 keinen Substituenten tragen und in Position 3 einen Alkylrest, insbesondere $(C_1$-$C_3)$Alkyl, wie beispielsweise 3-Methylpyrazolon-5.

Die genannten Kuppler können sowohl in Mischung untereinander, bevorzugt aber einzeln im lichtempfindlichen Gemisch enthalten sein.

Das Äquivalentverhältnis von Kuppler zur o-Chinondiazidverbindung liegt bei 0,5 bis 3, vorzugsweise bei 0,8 bis 2.

Als o-Chinondiazidverbindungen sind grundsätzlich alle Verbindungen dieses Strukturtyps geeignet. Typische Verbindungen werden zum Beispiel von Jaromir Kosar in: Light-Sensitive Systems, John Wiley & Sons, Inc., New York, S. 194 bis 214 und S. 321 bis 330 (1965) und in den DE-C-938 233, 1 124 817, 1 109 521, 1 120 273, 1 114 705 und 1 543 721 sowie in den DE-A-2 742 631 und 2 828 037 genannt.

Insbesondere werden die Sulfonsäurederivate, vorzugsweise die Ester, mit aromatischen Hydroxyverbindungen verwendet. Die Sulfonsäuregruppe steht im allgemeinen in der 4- oder 5-Stellung des Naphthalins. Als aromatische Hydroxyverbindungen werden im besonderen 2,4-Dihydroxybenzophenon, 2,3,4-Trihydroxybenzophenon, 4-(2-Phenyl-prop-2-yl)-phenol und Pyrogallol genannt.

Ebenso können polymergebundene o-Chinondiazide verwendet werden. Als Polymere kommen Kondensationsprodukte von ein- und mehrwertigen Phenolen mit Aldehyden oder Aceton und Polyvinylphenole in Frage. Das Molekulargewicht der Polymeren liegt vorzugsweise bei 800 bis 8.000 Dalton.

Die Menge der o-Chinondiazidverbindungen in dem lichtempfindlichen Gemisch liegt im allgemeinen bei 10 bis 30, vorzugsweise bei 15 bis 25 Gew.-%, bezogen auf den Gehalt an Feststoffen bzw. an nichtflüchtigen Bestandteilen.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinon-2-diazid-4-sulfonsäurechlorid, chromophor substituierte Trihalogenmethyl-s-triazine oder Diazoniumsalze. Besonders bevorzugt ist 1,2-Naphthochinon-2-diazid-4-sulfonsäurechlorid.

Zur Verbesserung der filmbildenden Eigenschaften werden dem lichtempfindlichen Gemisch ferner polymere, wasserunlösliche Bindemittel zugesetzt, die sowohl in organischen Lösungsmitteln löslich sind als auch in wässrig-alkalischen Lösungen löslich oder zumindest quellbar sind. Beispielsweise kommen Phenol- oder Kresol-Formaldehydharze, sogenannte Novolake, welche auch in bekannter Weise durch Umsetzung mit Epoxiden, Isocyanaten etc. modifiziert sein können, in Frage.

Die filmbildenden Phenolharze haben vorzugsweise ein Molekulargewicht von etwa 300 bis 5.000 und werden durch Kondensation von Phenol oder substituierten Phenolen mit Formaldehyd hergestellt. Geeignete substituierte Phenole sind Kresol, Xylenol, Butylphenol und ähnliche. Die besonders bevorzugten alkalilöslichen filmbildenden Phenolharze sind Phenol/Formaldehyd-Novolake, Kresol/Formaldehyd-Novolake und phenolmodifizierte Xylenol/Formaldehyd-Novolake.

Des weiteren eignen sich Polymere aus Vinylphenol oder Isopropenylphenol, Copolymere dieser Verbindungen mit Alkylacrylaten, Alkylmethacrylaten, Styrol u.a. (vgl. DE-A-3 406 927).

Die Menge des Bindemittels ist in weiten Grenzen variierbar; bevorzugt werden jedoch bei niedermolekularen o-Chinondiaziden Anteile des Bindemittels von 30 bis 90 Gew.-%, besonders bevorzugt 55 bis 85 Gew.-%, bezogen auf die nichtflüchtigen Bestandteile. Bei Verwendung polymergebundener o-Chinondiazide kann auf das Bindemittel ganz oder teilweise verzichtet werden; der Bindemittelgehalt beträgt dort vorzugsweise 0 bis 30 Gew.-%, bezogen auf die nichtflüchtigen Bestandteile.

Das Äquivalentverhältnis von o-Chinondiazid zu den phenolischen Hydroxylgruppen des Bindemittels beträgt 0,03 bis 0,3, vorzugsweise 0,06 bis 0,2.

Zur Anpassung an spezielle Erfordernisse können den Schichten noch Additive wie Weichmacher, z.B. Polyvinylether (DE-A-1 622 301) oder hydriertes Kolophoniumharz (DE-A-3 023 201) zugesetzt werden. Ferner werden Haftvermittler, Pigmente, Farbstoffe, Farbbildner und ggf. UV-Absorber genannt. Als Farbstoffe sind besonders bevorzugt Triphenylmethanfarbstoffe.

Als Träger für das lichtempfindliche Gemisch können die in der Reproduktionstechnik üblichen verwendet werden. Es handelt sich z.B. um Platten oder Folien aus Metall, wie Aluminium oder Zink, mit entsprechend vorbehandelter Oberfläche, Mehrmetallplatten, z.B. aus Chrom/Messing, Chrom/Kupfer/Aluminium, Chrom/Kupfer/Zink, ferner Papierfolien, Kunststoff-Folien, für den Siebdruck geeignete Gewebe oder metallisierte Isolierstoffplatten. Bevorzugt werden Aluminiumbleche mit entsprechender Vorbehandlung zur Verbesserung der Haftung der Kopierschicht und zur Verbesserung der Hydrophilie der Schichtträgeroberfläche, beispielsweise mechanisch, chemisch oder elektrochemisch aufgerauhte, ggf. anodisierte und mit Phosphonsäuren, Silikaten oder Polyarylamiden u.a. nachbehandelte Aluminiumträger.

Die Beschichtung des Trägermaterials erfolgt in an sich bekannter Weise, z.B. durch Antrag mittels Walzen oder Wannen, durch Aufsprühen oder Begießen. Ein geeigneter Bereich des Schichtgewichtes auf Trockenbasis liegt zwischen 1,0 und 3,0 $g/m^2$. Niedrigere Überzugsmengen begünstigen zwar die photographische Empfindlichkeit, haben aber den Nachteil einer verringerten Filmfestigkeit und einer verringerten

Druckauflagenhöhe.

Zum Belichten können die üblichen Lichtquellen wie Kohlebogen-, Xenonimpuls- oder metallhalogeniddotierte Quecksilberdampflampen verwendet werden. Auch die Bebilderung z.T. ohne Maske mit Laserstrahlen, Röntgenstrahlen und Elektronenstrahlen ist möglich.

Die lichtempfindlichen Kopiermaterialien werden nach der bildmäßigen Belichtung in üblicher Weise mit wäßrig-alkalischen Lösungen, die auch kleinere Mengen organischer Lösungs- oder Netzmittel enthalten können, entwickelt. Diese Entwickler besitzen im allgemeinen einen pH-Wert von 10 bis 14 und enthalten im wesentlichen Alkaliphosphate, -silikate, -borate und/oder -hydroxide, ferner Tenside und ggf. in geringen Mengen organische Lösungsmittel. Die Entwicklung kann durch Tauchen, Bürsten, Sprühen in geeigneten Verarbeitungsgeräten oder manuell durch Überwischen oder Reiben mit einem Tampon erfolgen.

Zur Erhöhung der chemischen und mechanischen Widerstandsfähigkeit - z.B. für die Anwendung im Offsetdruck - können die Schichten nach dem Entwickeln für kurze Zeit auf erhöhte Temperaturen erwärmt werden (GB-A-1 154 749). Ein solches Nachhärten hat den Vorteil in einer möglichen Erhöhung der Verarbeitungsgeschwindigkeit, oder die Belichtung kann - bei gleicher Verarbeitungsgeschwindigkeit - mit Lampen geringerer Leistung ausgeführt werden.

Bevorzugte Anwendung finden die erfindungsgemäßen lichtempfindlichen Gemische bei der Herstellung von Druckformen, insbesondere Offsetdruckformen. Dadurch wird aber die Verwendung der erfindungsgemäßen Mischungen in anderen photolithographischen Prozessen nicht eingeschränkt. Ebenso ist die Anwendung auf dem Photoresistgebiet möglich.

Die Erfindung wird anhand der nachfolgenden Beispiele näher erläutert.

Beispiel 1

Es wurde eine Beschichtungslösung bestehend aus

1,0 Gt des Veresterungsproduktes aus 1 mol 2,3,4-Trihydroxybenzophenon mit 3 mol 1,2-Naphthochinon-2-diazid-5-sulfonsäurechlorid,
5,2 Gt eines Kresol-Formaldehyd-Novolaks mit einem Erweichungspunkt von 105 - 120° C nach Kapillarmethode DIN 53 181,
0,7 Gt 3-Hydroxy-acetylacetanilid,
0,1 Gt 1,2-Naphthochinon-2-diazid-4-sulfonsäurechlorid,
0,05Gt Kristallviolett (C.I. 42 555) in
5 Gt 2-Methoxyethanol und
93 Gt Tetrahydrofuran
hergestellt.

Das Äquivalentverhältnis des Kupplers 3-Hydroxy-acetylacetanilid zum 1,2-Naphthochinondiazid betrug 1,11 : 1, das des 1,2-Naphthochinondiazids zu den phenolischen Hydroxylgruppen im Bindemittel 0,075 : 1.

Die Beschichtungslösung wurde auf einen 0,3 mm dicken Aluminiumträger, der elektrochemisch aufgerauht, anodisiert und mit Polyvinylphosphonsäure hydrophiliert worden war, aufgeschleudert und anschließend bei 100° C 1 Minute lang getrocknet. Das Schichtgewicht betrug 2,3 g/m$^2$.

Die in dieser Weise hergestellte Offsetdruckplatte wurde mit einer Kopiervorlage, die einen Halbtonkeil, Mikrolinien von einer Stärke zwischen 4 und 75 µm und Rasterpunkte von 0,5 bis 5 % Flächendeckung enthielt, bedeckt. Anschließend wurde mit einer Quecksilberhochdrucklampe (5.000 W) 60 Sekunden bildmäßig belichtet. Die Entwicklung der Offsetdruckplatte erfolgte mit einem alkalischen Entwickler der Zusammensetzung:

5,3 Gt Natriummetasilikat x 9 $H_2O$,
3,4 Gt Trinatriumphosphat x 12 $H_2O$,
0,3 Gt Natriumdihydrogenphosphat,
91 Gt vollentsalztes Wasser.

Nach einer Entwicklungsdauer von 1 Minute war die Stufe 4 des 13stufigen Halbtonkeils frei entwickelt, während die Stufe 10 voll gedeckt war. Die demnach 5 anbelichteten Stufen zeigten exzellent wiedergegebene feine Strukturelemente; die Schicht stand an den Bildstellen einwandfrei. Auch nach einer Entwicklungszeit von 3 Minuten konnte keine Verschlechterung der hervorragenden Auflösung festgestellt werden; die nicht belichteten Bereiche der Schicht waren daher gegenüber dem Entwickler resistent.

Vergleichsbeispiel 1

Es wurde eine Beschichtungslösung bestehend aus
1,0 Gt des Veresterungsproduktes aus 1 mol 2,3,4-Trihydroxybenzophenon mit 3 mol 1,2-Naphthochinon-2-diazid-5-sulfonsäurechlorid,
5,0 Gt eines Kresol-Formaldehyd-Novolaks mit einem Erweichungspunkt von 105 - 120° C,
0,1 Gt 1,2-Naphthochinon-2-diazid-4-sulfonsäurechlorid,
0,06 Gt Kristallviolett (C.I. 42 555) in 5,0 Gt 2-Methoxyethanol und
94 Gt Tetrahydrofuran
hergestellt.

Es wurde der gleiche Träger wie in Beispiel 1 in der gleichen Weise wie dort beschrieben beschichtet, bildmäßig belichtet und entwickelt.

Nach einer Entwicklungsdauer von 1 Minute war die Stufe 3 des 13stufigen Halbtonkeils nicht vollständig frei, während die Stufe 9 noch gedeckt war. Die Schicht war daher etwa um den Faktor 1,5 weniger lichtempfindlich als die des Beispiels 1.

Vergleichsbeispiel 2

Es wurde eine Beschichtungslösung bestehend aus
1,0 Gt des Veresterungsproduktes aus 1 mol 2,3,4-Trihydroxybenzophenon mit 3 mol 1,2-Naphthochinon-2-diazid-5-sulfonsäurechlorid,
0,7 Gt des Kondensationsproduktes aus 2,3,4-Trihydroxybenzophenon und Formaldehyd, beschrieben in der EP-A-0 010 749, Beispiel 1, 5 und 7,
5,0 Gt eines Kresol-Formaldehyd-Novolaks mit einem Erweichungspunkt von 105 - 120° C nach Kapillarmethode DIN 53 181,
0,7 Gt 3-Hydroxy-acetylacetanilid,
0,1 Gt 1,2-Naphthochinon-2-diazid-4-sulfonsäurechlorid,
0,06 Gt Kristallviolett (C.I. 42 555) in
5 Gt 2-Methoxyethanol und
92 Gt Tetrahydrofuran
hergestellt.

Entsprechend Beispiel 1 wurde die auf Aluminium aufgetragene Schicht bildmäßig belichtet und entwickelt. Im 13stufigen Halbtonkeil war die Stufe 4 frei, die Stufe 12 gedeckt. Die Lichtempfindlichkeit entsprach daher der Schicht aus Beispiel 1, jedoch war die Gradation um zwei Stufen weicher.

Beispiele 2 bis 4

Die Beispiele entsprechen dem Beispiel 1 mit der Ausnahme, daß anstelle von 0,7 Gt 3-Hydroxy-acetylacetanilid äquimolare Anteile unten beschriebener Kupplungsreagenzien eingesetzt wurden.

Die Platten wurden 30 Sekunden belichtet und mit einem Entwickler bestehend aus

8,4 Gt Natriummetasilikat x 9 $H_2O$,
0,8 Gt Natriumhydroxid,
1,5 Gt Borax und
89,3 Gt vollentsalztem Wasser
entwickelt.

Die Kupplungsreagenzien, deren Gewichtsanteile in der Schicht sowie die mit diesen Schichten resultierende Lichtempfindlichkeit sind in Tabelle 1 zusammengestellt.

Tabelle 1

| Beisp. | Kupplungsreagenz | Zusatz | Lichtempfindlichkeit |
|---|---|---|---|
| 2 | Barbitursäure | 0,5 Gt | Stufe 3 - 4 frei |
| 3 | Dimedon | 0,5 Gt | Stufe 2 - 3 frei |
| 4 | 3-Methylpyrazolon-5 | 0,4 Gt | Stufe 3 - 4 frei |

Vergleichsbeispiel 3

Entsprechend den Beispielen 2 bis 4 wurden Beschichtungslösungen hergestellt, mit der Ausnahme, daß auf ein Kupplungsreagenz verzichtet wurde. Beschichtung, Belichtung und Entwicklung entsprachen wiederum den Beispielen 2 bis 4. Im Vergleichsbeispiel konnte die Stufe 2 des Halbtonkeils völlig frei entwickelt werden. Die Lichtempfindlichkeit ist daher geringer als diejenige, die in den Beispielen 2 bis 4 gemessen werden konnte.

Beispiele 5 bis 7

Es wurde eine Beschichtungslösung bestehend aus
1,5 Gt des Veresterungsproduktes aus 1 mol 2,3,4-Trihydroxybenzophenon mit 3 mol 1,2-Naphthochinon-2-diazid-5-sulfonsäurechlorid,
6 Gt eines Kresol-Formaldehyd-Novolaks mit einem Erweichungspunkt von 105 - 120° C nach Kapillarmethode DIN 53 181,
0,2 Gt 1,2-Naphthochinon-2-diazid-4-sulfonsäurechlorid,
0,07 Gt Kristallviolett (C.I. 42 555) in
5 Gt 2-Methoxyethanol und
92 Gt Tetrahydrofuran
hergestellt.

Die Beschichtungslösung enthielt ferner jeweils die in Tabelle 2 zusammengestellten Kupplungsreagenzien.

Entsprechend Beispiel 1 wurde die Beschichtungslösung auf einen Aluminiumträger aufgetragen, und analog zu Beispiel 2 wurden die Platten bildmäßig belichtet und entwickelt. Die Lichtempfindlichkeit liegt zwischen 4 und 5 Stufen (Tabelle 2).

Tabelle 2

| Beisp. | Kupplungsreagenz | Zusatz | Lichtempfindlichkeit |
|---|---|---|---|
| 5 | m-Bis-acetylacetamino-benzol | 0,7 Gt | Stufe 5 frei |
| 6 | Acetylacetanilid | 0,4 Gt | Stufe 4 frei |
| 7 | 4-Acetylacetamino-N-hydroxyethylbenzamid | 0,6 Gt | Stufe 4 frei |

Vergleichsbeispiel 4

Entsprechend den Beispielen 5 bis 7 wurde eine Beschichtungslösung hergestellt, mit der Ausnahme, daß auf ein Kupplungsreagenz verzichtet wurde. Beschichtung, Belichtung und Entwicklung entsprach wiederum den Beispielen 5 bis 7. Im Vergleichsbeispiel konnte die Stufe 2 des Halbtonkeils völlig frei entwickelt werden. Die Lichtempfindlichkeit ist daher geringer als diejenige, die in den Beispielen 5 bis 7 ermittelt werden konnte.

Beispiel 8

Es wird eine Beschichtungslösung bestehend aus
5 Gt eines polymer gebundenen 1,2-Naphthochinon-2-diazid-5-sulfonsäureesters, dessen Herstellung unten beschrieben ist,
1 Gt 1,3-Bis-acetylacetamino-benzol und
94 Gt Tetrahydrofuran
hergestellt.

Das Äquivalentverhältnis des 1,3-Bis-acetylacetamino-benzols zu dem 1,2-Naphthochinondiazid betrug 1 : 1, das Verhältnis von 1,2-Naphthochinondiazid zu den phenolischen Hydroxylgruppen im Polymeren 0,25 : 1.

Die Beschichtungslösung wurde entsprechend den Angaben in Beispiel 1 auf einen Aluminiumträger aufgetragen, 60 Sekunden bildmäßig belichtet und mit einer 3%igen Natriumsilikatlösung 1 Minute entwickelt. Die Stufe 3 des 13stufigen Halbtonkeils war frei entwickelt; die Rasterpunkte und Mikrolinien waren gut wiedergegeben.

Herstellung des polymergebundenen 1,2-Naphthochinondiazid-5-sulfonsäureesters

120 g Polyhydroxystyrol (Fa. Maruzen Oil Company) wurden in 1.000 ml Tetrahydrofuran vorgelegt, auf 30° C erwärmt und unter Rühren 53,7 g 1,2-Naphthochinon-2-diazid-5-sulfonsäurechlorid dazugelöst. Durch Zutropfen einer 10%igen wäßrigen Kaliumcarbonat-Lösung wurde ein pH-Wert von 10 erreicht und 30 Minuten nachgerührt. Das Produkt wurde in Eiswasser ausgefällt, in Tetrahydrofuran gelöst, um wieder in Eiswasser umgefällt zu werden. Nach dem Absaugen des Produktes wurde es 1 Tag i. Vak. bei Raumtemperatur über $P_4O_{10}$ getrocknet. Im Produkt waren 20 % der phenolischen Hydroxylgruppen verestert (ermittelt durch Elementaranalyse).

Vergleichsbeispiel 5

Es wurde eine Beschichtungslösung bestehend aus
5 Gt des polymer gebundenen 1,2-Naphthochinon-2-diazid-5-sulfonsäureesters aus Beispiel 8 und
95 Gt Tetrahydrofuran
hergestellt.

Das Äquivalentverhältnis von 1,2-Naphthochinondiazidgruppen zu den phenolischen Hydroxylgruppen im Polymeren betrug wie in Beispiel 8 0,25 : 1.

Die Beschichtungslösung wurde entsprechend den Angaben in Beispiel 1 auf einen Aluminiumträger aufgetragen, 60 Sekunden bildmäßig belichtet und mit einer 3%igen Natriumsilikatlösung entsprechend Beispiel 8 1 Minute entwickelt.

Nach Auswertung des Halbtonkeils konnte festgestellt werden, daß die Lichtempfindlichkeit um den Faktor 1,5 geringer war als die des Beispiels 8.

Beispiele 9 bis 12

Die Beispiele entsprechen dem Beispiel 8 mit der Ausnahme, daß anstelle von 1 Gt 1,3-Bis-acetylacetamino-benzol äquimolare Anteile unten beschriebener Kupplungsreagenzien eingesetzt wurden, und daß in diesem Fall 80 Sekunden bildmäßig belichtet wurde.

Die Kupplungsreagenzien, deren Gewichtsteile in der Schicht sowie die mit diesen Reagenzien resultierende Lichtempfindlichkeit der entsprechenden Offsetdruckplatten sind in Tabelle 3 zusammengestellt. Die Rasterpunkte und Mikrolinien waren gut wiedergegeben.

Tabelle 3

| Beisp. | Kupplungsreagenz | Zusatz | Lichtempfindlichkeit |
|---|---|---|---|
| 9 | Resorcin | 0,8 Gt | Stufe 4 frei |
| 10 | 2,4-Dihydroxy-N-hydroxyethylbenzamid | 1,6 Gt | Stufe 4 frei |
| 11 | 3,5-Dihydroxy-N-hydroxyethylbenzamid | 1,6 Gt | Stufe 5 frei |
| 12 | Resorcinmonohydroxyethylether | 1,0 Gt | Stufe 4 frei |

Vergleichsbeispiel 6

Entsprechend den Beispielen 9 bis 12 wurden Beschichtungslösungen hergestellt, mit der Ausnahme, daß auf ein Kupplungsreagenz verzichtet wurde. Beschichtung, Belichtung und Entwicklung entsprachen wiederum den Beispielen 9 bis 12. Als Ergebnis wurde eine Lichtempfindlichkeit ermittelt, nach der die Stufe 3 eines 13stufigen Halbtonkeils frei entwickelt wurde. Die Lichtempfindlichkeit im Vergleichsbeispiel ist daher geringer als die in den Beispielen 9 bis 12.

**Ansprüche**

1. Positiv arbeitendes lichtempfindliches Gemisch, im wesentlichen enthaltend ein o-Chinondiazid und ein Bindemittel, dadurch gekennzeichnet, daß das lichtempfindliche Gemisch eine Verbindung (Kuppler) enthält, die mit dem o-Chinondiazid eine Azokupplung ausbilden kann.

2. Lichtempfindliches Gemisch nach Anspruch 1, dadurch gekennzeichnet, daß der Kuppler eine methylenaktive Verbindung und/oder eine aromatische bzw. heteroaromatische Verbindung mit mindestens einem, die elektrophile Substitution am Kern fördernden, Substituenten ist.

3. Lichtempfindliches Gemisch nach den Ansprüchen 1 oder 2, dadurch gekennzeichnet, daß das Äquivalentverhältnis von Kuppler zu o-Chinondiazid 0,5 bis 3 beträgt.

4. Lichtempfindliches Gemisch nach den Ansprüchen 1 bis 3, dadurch gekennzeichnet, daß das Gemisch ein Lösungsmittel enthält.

5. Lichtempfindliches Gemisch nach einem oder mehreren der Ansprüche 1 bis 4, dadurch gekennzeichnet, daß der Kuppler eine Verbindung der allgemeinen Formel I

$$(R_1)_n - Q - CH_2 - \overset{\overset{O}{||}}{C} - R_2 \qquad I$$

ist, worin n = 1, Q = Carbonyl und
n = 0, Q = Cyano bedeutet,
$R_1$, $R_2$ gleich oder verschieden sind und Alkyl, Cycloalkyl, Alkoxy, Alkyl-, Aryl- oder Acylamino, Alkoxycarbonylamido, Heteroaryl oder Heteroarylimino bedeuten.

6. Lichtempfindliches Gemisch nach einem oder mehreren der Ansprüche 1 bis 5, dadurch gekennzeichnet, daß der Kuppler eine Verbindung der allgemeinen Formel II

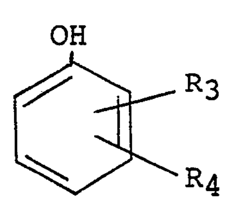

II

ist, worin
$R_3$, $R_4$ gleich oder verschieden sind und Wasserstoff, Alkyl, Cycloalkyl, Aryl, Heteroaryl, Alkoxy, Hydroxyl, ω-Hydroxyalkoxy, Aryl, Acyl, Amino, Aminoalkyl und Amidoacyl bedeuten.

7. Lichtempfindliches Gemisch nach einem oder mehreren der Ansprüche 1 bis 4, dadurch gekennzeichnet, daß der Kuppler eine Verbindung der allgemeinen Formel III

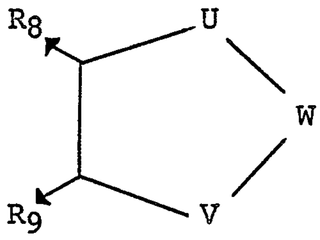

III

ist, worin

U,V,W gleich oder verschieden sind, vorzugsweise aber verschieden sind und jeweils eine der folgenden Gruppen bedeuten:

Methylen, ggf. substituiert durch Alkyl, Aryl, insbesondere Phenyl, Carboxyl, Carboxylamid; Carbonyl, Carbonylimino, Schwefel, Selen, Sauerstoff, Amino, Imino, ggf. substituiert durch Alkyl oder Aryl;

$R_8$ und $R_9$ gleich oder verschieden sind und Wasserstoff, Alkyl, insbesondere $(C_1$-$C_{11})$Alkyl, bevorzugt $(C_1$-$C_3)$Alkyl, Hydroxyl oder Oxo bedeuten.

8. Lichtempfindliches Gemisch nach einem oder mehreren der Ansprüche 1 bis 7, dadurch gekennzeichnet, daß als o-Chinondiazide deren Sulfonsäureester mit aromatischen Hydroxyverbindungen verwendet werden.

9. Lichtempfindliches Gemisch nach Anspruch 8, dadurch gekennzeichnet, daß die aromatischen Hydroxyverbindungen Polymere mit einem Molekulargewicht von 800 bis 8.000 Dalton sind.

10. Lichtempfindliches Gemisch nach einem oder mehreren der Ansprüche 1 bis 9, dadurch gekennzeichnet, daß das lichtempfindliche Gemisch als o-Chinondiazid zusätzlich 1,2-Naphthochinon-2-diazid-4-sulfonsäurechlorid und einen Farbstoff enthält.

11. Lichtempfindliches Gemisch nach einem oder mehreren der Ansprüche 1 bis 10, dadurch gekennzeichnet, daß das Bindemittel zu 30 bis 90 Gew.-%, bezogen auf die nichtflüchtigen Bestandteile, enthalten ist.

12. Lichtempfindliches Gemisch nach einem oder mehreren der Ansprüche 1 bis 11, dadurch gekennzeichnet, daß die o-Chinondiazidverbindung zu 10 bis 30 Gew.-%, bezogen auf die nichtflüchtigen Bestandteile, enthalten ist.

13. Lichtempfindliches Gemisch nach einem oder mehreren der Ansprüche 1 bis 12, dadurch gekennzeichnet, daß das Äquivalentverhältnis von o-Chinondiazid zu phenolischen Hydroxylgruppen im Bindemittel 0,03 bis 0,3 beträgt.

14. Lichtempfindliches Aufzeichnungsmaterial, bestehend aus einem Substrat und einer lichtempfindlichen Schicht, dadurch gekennzeichnet, daß die lichtempfindliche Schicht aus einem lichtempfindlichen Gemisch nach den Ansprüchen 1 bis 13 besteht.

15. Verfahren zur Herstellung eines Reliefbildes, dadurch gekennzeichnet, daß ein in der Reproduktionstechnik übliches Substrat mechanisch, chemisch oder elektroche misch aufgerauht wird, ggf. anodisiert und nachbehandelt wird, daß die Beschichtung des Substrates mit dem lichtempfindlichen Gemisch bis zu einem Trockenschichtgewicht von 1,0 bis 3,0 g/m$^2$ erfolgt, daß bildmäßig belichtet wird und anschließend mit einem wäßrig-alkalischen Entwickler entwickelt wird sowie ggf. durch Erwärmen auf hohe Temperaturen nachgehärtet wird.